# EUROPEAN PATENT SPECIFICATION

(11) **EP 4 184 185 B1**
(45) Date of publication and mention of the grant of the patent: **06.03.2024**
(21) Application number: 21209205.0
(22) Date of filing: 19.11.2021
(51) Int. Cl.: G01R 29/10, G01R 29/08, G01R 31/28

(54) **TEST SYSTEM FOR TESTING A DEVICE-UNDER-TEST**
TESTSYSTEM ZUM TESTEN EINER ZU TESTENDEN VORRICHTUNG
SYSTÈME DE TEST POUR TESTER UN DISPOSITIF SOUS TEST

(43) Date of publication of application: 24.05.2023
(73) Proprietor: Rohde & Schwarz GmbH & Co. KG, 81671 München (DE)
(72) Inventor: Rowell, Corbett, Dr., 83209 Prien am Chiemsee (DE)
(74) Representative: Novagraaf Group

(56) References cited:
- WO-A1-2020/074772
- US-A1- 2016 285 481
- US-A1- 2019 235 003
- ROHDE ET AL: "Characterizing Active Phased Array Antennas", APPLICATIONS NOTE,, 1 August 2016 (2016-08-01), XP002767222,

## Description

### TECHNICAL FIELD OF THE INVENTION

The invention relates to a test system for testing a device under test, in particular a wireless communication device.

### BACKGROUND OF THE INVENTION

Test systems for wireless communication devices, for instance user equipment or base stations, often include antenna arrays which are used to forward signals to the wireless communication device under test or to receive signals from the device. Such antenna arrays can form a so-called phased array which can steer an RF signal to point to a certain direction.

Known phased array antennas use control means, such as phase shifters or power amplifiers, to adjust the phase shift of each antenna in the array and generate a signal with desired characteristics. However, this can lead to a high complexity and cost of the antenna array, as typically a large number of control means is required.

WO 2020/074772 A1 discloses an antenna arrangement for base station testing. The antenna arrangement is divided into sub-arrays with amplitude and phase adjustments specific with each antenna sub-array.

Thus, it is an objective to provide an improved test system for a device under test, in particular a wireless communication device, which avoids the above-mentioned disadvantages.

### SUMMARY OF THE INVENTION

The object of the present invention is achieved by the solution provided in the enclosed independent claims. Advantageous implementations of the present invention are further defined in the dependent claims.

According to a first aspect, the invention relates to a test system for testing a device-under-test, DUT, comprising: a transmitting and/or receiving device; and an antenna array which is connected to the transmitting and/or receiving device; wherein the antenna array comprises a plurality of antenna elements being grouped in at least two subgroups; wherein the antenna elements in at least one subgroup of the antenna array are configured to apply an amplitude and/or phase shift to a signal which is transmitted to the DUT or received from the DUT; wherein said amplitude and/or phase shift is provided by a weight generator of the test system; and wherein the weight generator is configured to provide the amplitude and/or phase shift to the antenna elements of the at least one subgroup by means of an aggregated analog and digital weighting.

This achieves the advantage that, by dividing the antenna array into subgroups of a plurality of antenna elements and performing both analog and digital weighting, a complexity of the antenna array, in particular of its control elements, can be reduced.

In particular, providing the amplitude and/or phase shift to the antenna elements of the at least one subgroup may refer to controlling the amplitude and/or phase weighting of signals received from or send to the respective antenna elements.

Thereby, the phrase "weighting" may refer to an amplification respectively a phase shift that is applied to a signal transmitted from / or received by the antenna elements. By appropriate weighting, different signal patterns and/or signal shapes, in particular a directional signal transmission or reception, can be achieved.

In other words, the weight generator is configured to control an amplitude and/or phase weighting of the signals transmitted to / received from each antenna element by using both analog and digital weighting techniques. The resulting weighting of the signal received from / send to each respective antenna element is, thus, an aggregate of the analog and digital weighting.

The system, in particular the weight generator, can comprise at least two weighting units for analog and digital beamforming, i.e. for hybrid beamforming. The weight generator can further comprise a processing unit which is configured to calculate the aggregated analog and digital weighting. The processing unit can be communicatively connected to the weighting units, in particular to the digital weighting means.

The weight generator can be configured to calculate the aggregated analog and digital weighting based on a current DUT and/or based on feedback from the current DUT.

The signal can be an RF signal or a part of an RF signal. The signal can be coherent.

The antenna elements can be arranged such that the emitted electromagnetic (EM) waves are plane waves in the near field of the antenna array.

The antenna array can form a phased array antenna.

The transmitter and/or receiver device can be configured to measure the power and/or phase of added signals received by the antenna elements in at least one subgroup. The signal can be added analogously and/or digitally by the weight generator. The DUT can be tested based on such measurements.

In an embodiment, the weight generator is configured to provide the same amplitude and/or phase shift to all antenna elements in one subgroup of the antenna array.

Controlling all antenna elements within one subgroup with the same weighting parameters (i.e., with the same amplitude and/or phase weighting) can significantly reduce the complexity of the weighting, both in terms of required components and required processing power.

In an embodiment, the antenna elements in each of the at least two subgroups forms a respective ring around a central point of the antenna array.

Due to this symmetrical arrangement, the overall amount of components required to control the antenna elements and, thus, the complexity of the system can be reduced. Further, this symmetrical arrangement of the antenna elements can lead to a highly symmetrical signal, even if all antenna elements of one subgroup are provided with the same amplitude and/or phase shift.

In an embodiment, the rings are arranged concentrically in a plane perpendicular to the DUT.

In an embodiment, the system comprises connection lines of different lengths which are arranged to connect the weight generator with the at least two subgroups.

The connection lines can comprise cables, conductors or other wired connection means. The system can comprise one connection line for each subgroup.

In an embodiment, the system further comprises a connection device which is arranged to connect the transmitter and/or receiver device with the antenna elements of the at least two subgroups, wherein the connection device comprises splitter and/or combiner units.

In an embodiment, at least one splitter and/or combiner unit of the connection device is connected to the plurality of antenna elements of one of the subgroups and is configured to exchange signals between said antenna elements and the transmitter and/or receiver device.

In an embodiment, the weight generator is configured to switch off at least one subgroup of the antenna array based on the aggregated analog and digital weighting. Switching off one subgroup may refer to switching off all antenna elements within the subgroup.

In an embodiment, each of the at least two subgroups of the antenna array are operable in an activated and a deactivated operation mode.

In an embodiment, the weight generator is configured to activate and/or deactivate the respective subgroups based on a predefined activation sequence or based on feedback from the DUT.

In an embodiment, the weight generator is configured to provide the amplitude and/or phase shift to the antenna elements of the respective subgroups based on a predefined weighting sequence or based on feedback from the DUT.

In an embodiment, the weight generator is configured to calculate the predefined activation sequence and/or the predefined weighting sequence based on a trainable algorithm, in particular a machine learning algorithm, which is trained by previously recorded data and/or signals.

The predefined activation sequence and/or the predefined weighting sequence can be part of a dataset which represents a specific test scenario for the DUT.

In an embodiment, the weight generator is configured to determine the amplitude and/or phase shift for the antenna elements of the at least one subgroup at least partially based on a distance between the DUT and the antenna array.

### BRIEF DESCRIPTION OF THE DRAWINGS

The invention will be explained in the followings together with the figures.
- Fig. 1: shows a schematic diagram of a test system for testing a DUT according to an embodiment; and
- Fig. 2: shows a schematic diagram of a test system according to an embodiment.

### DETAILED DESCRIPTION OF THE PREFERRED EMBODIMENTS

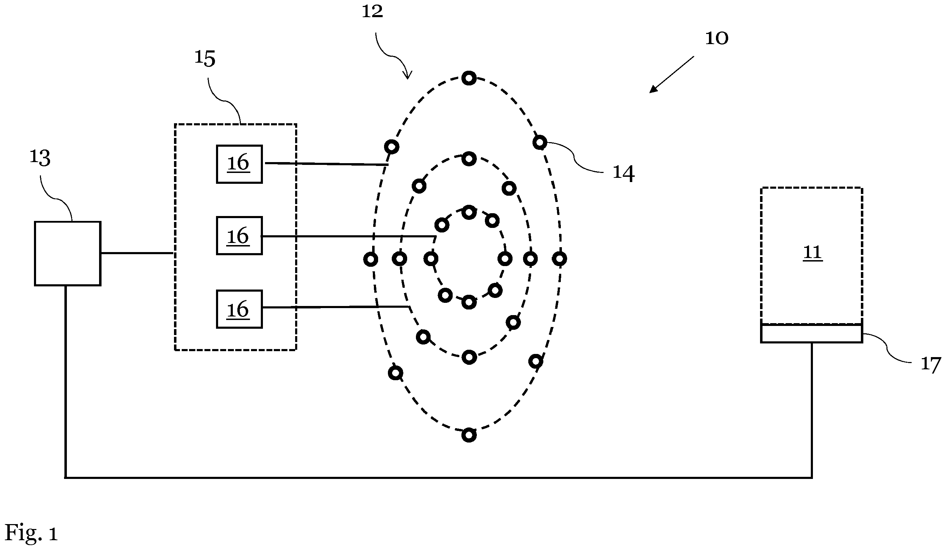

Fig. 1 shows a test system 10 for testing a DUT 11 according to an embodiment.

The test system 100 comprises a transmitting and/or receiving device 13 and an antenna array 12 which is connected to the transmitting and/or receiving device 13. Thereby, said antenna array 12 comprises a plurality of antenna elements 14 being grouped in at least two subgroups, wherein the antenna elements 14 in at least one subgroup of the antenna array 12 are configured to apply an amplitude and/or phase shift to a signal which is transmitted to the DUT 11 or received from the DUT 11. Said amplitude and/or phase shift is provided by a weight generator 15 of the test system 10, which is configured to provide the amplitude and/or phase shift by means of an aggregated analog and digital weighting.

The DUT 11 can be a wireless communication device, e.g. a user equipment or a base station, which itself can comprise an antenna for transmitting and/or receiving signals.

The system 10 can comprise a holder 17 for the DUT 11. By means of said holder 17, the DUT 11 can be arranged at a fixed location relative to the antenna array 12. The holder 17 can also be configured to dynamically change the distance and/or orientation between the DUT 11 and the antenna array 12. The weight generator can be configured to adapt the weighting of the signal at the antenna elements based on a distance between DUT 11 and antenna array 12 and/or based on an orientation of the DUT 11 to the antenna array 12.

The exemplary antenna array in Fig. 1 comprises three subgroups. Thereby, each subgroup forms a ring which is arranged concentrically around a center point of the array 12. In this way, a good coverage (e.g., of WFS) can be achieved.

The antenna elements 14 in each subgroup can be arranged in a rational symmetric manner. In particular, the antenna elements 14 of the array 12 can be arranged in a star-configuration.

The rings can be arranged in a plane that lies perpendicular to the DUT 11.

Due to the symmetrical arrangement of the antenna elements 14 relative to the DUT 11, each antenna element 14 within one subgroup can be provided with the same weighting parameters (i.e., with the same analog and/or phase weighting). This can further reduce the complexity of the weighting.

Furthermore, the overall amount of components required to control the antenna array 12 can be reduced. This can also lead to an enhancement of the signal quality, because by reducing the number of components, also irregularities of components (production tolerances / varying cable lengths etc.) in the overall system are reduced.

In particular, the weight generator 15 can provide different amplitude and/or phase shifts to antenna elements 14 in different subgroups.

The antenna array 12 can form a phased array antenna and can be configured to transmit and/or receive RF signals in a frequency range according to the 3G, 4G, 5G or 6G standard. In particular, the antenna array can be configured to transmit and/or receive millimeter wave signals.

The transmitter and/or receiver device can be an RF transceiver.

The transmitter and/or receiver device can comprise a vector signal generator, a vector signal analyzer, or a vector network analyzer. The transmitter and/or receiver device can comprise a plurality of outputs, e.g. one output for each subgroup of the antenna array 12.

The weight generator 15 can allocate an aggregate weighting between digital and analog weighting to each subgroup of the antenna array 12. The weighting can be based on discrete weights.

The weight generator 15 can comprise a plurality of weighting units 16, preferably one weighting unit 16 for each subgroup of the antenna array.

Each weighting unit 16 may comprise means for digital and/or analog weighting. Each weighting unit 16 can be configured to control an amplitude and/or a phase weighting performed by the antenna elements 14 in one subgroup of the antenna array 12.

For instance, each weighting unit 16 can be allocated to a subgroup of the antenna array 12 and can comprise a respective digital baseband processing unit for the subgroup. Each digital baseband processing unit can be connected to the antenna elements 14 of the respective subgroup via an RF chain comprising at least one phase shifter and/or power amplifier. Thereby, the system can comprise only one weighting unit 16 (e.g., with one means for digital beamforming) for each subgroup. Thus, the overall number of beamforming means can be reduced.

Preferably, each digital baseband processing unit comprises an A/D converter, e.g. to convert a digital control signal into an RF signal that is provided to an antenna element. Thereby, both the digital control signal and the RF signal can be weighted by the weight generator 15 depending on which subgroup it is fed to.

The weight generator 15 may further comprise a processing unit, which is configured to calculate a digital and an analog weighting and to control the weighting units 16 based on said calculation. Thereby, the weight generator 15 can take into account the aggregate of the analog and digital weighting.

In particular, the weight generator 15 can be configured to take the geometry of the antenna array, especially the arrangement of the subgroups, into account when determining the weighting (e.g., number of rings, diameter of each ring, number of antennas per ring, etc.). Furthermore, also the frequency range of a signal generated by the antenna array can depend on the antenna element 14 spacing.

The weight generator 15 can be configured to switch off at least one subgroup (weighting = 0) of the antenna array.

Each of the at least two subgroups of the antenna array 12 is operable in an activated and a deactivated operation mode. In other words, each subgroup of the antenna array 12 can be switched on and off.

The weight generator 15 can be configured to receive a feedback signal from the DUT 11, e.g., via a wireless or wired communication connection with the DUT 11.

The weight generator 15 can be configured to provide the amplitude and/or phase shift for the respective subgroups based on said feedback signal. The weight generator 15 can further be configured to activate and/or deactivate the respective subgroups based on the feedback from the DUT 11.

Alternatively or additionally, the weight generator 15 can be configured to provide the amplitude and/or phase shift for the respective subgroups based on a predefined weighting sequence. Additionally, or alternatively the weight generator 15 can be configured to activate and/or deactivate the respective subgroups based on a predefined activation sequence. In this way, weighting and/or switching for hybrid beamforming can be provided.

The predefined weighting sequence and/or the predefined activation sequence can be stored in a memory of the system 10.

The weight generator 15 can be configured to calculate the predefined activation sequence and/or the predefined weighting sequence based on a trainable algorithm, in particular a machine learning algorithm. The trainable algorithm can be trained by previously recorded data and/or signals, e.g. sample data from the DUT 11 or from other DUTs. The trainable algorithm can be executed by a trainable neural network, which can be comprised by the weight generator 15. Machine learning can also be used to generate training data for the DUT (e.g., training signals, etc.).

The predefined activation sequence and/or the predefined weighting sequence can be part of a dataset which represents a specific test scenario.

The weight generator 15 can further be configured to determine the amplitude and/or phase shift for the at least one subgroup of the antenna array 12 based on a distance between the DUT 11 (or the DUT holder 17) and the antenna array 12. In particular, the weighting for each subgroup of the antenna array 12 can be adapted based on the distance of the subgroup to the DUT 11. Also, other geometrical factors such as the orientation of the DUT 11 to the antenna array 12, respectively to the subgroups, or the size of the DUT 11, can be taken into account for determining the amplitude and/or phase shift of each subgroup.

In particular, the distance between the DUT 11 and the antenna array 12 can be adjustable. E.g., the DUT holder 17 of the system allows for an automated changing of the position and/or orientation to the antenna array 12. The weighting can be adjusted to a change of distance and/or orientation.

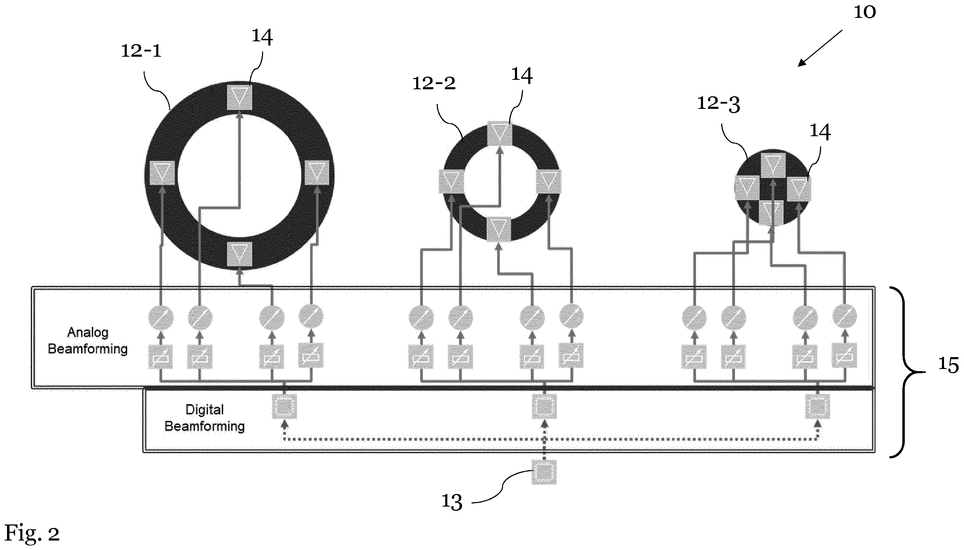

Fig. 2 shows a schematic diagram of the test system 10 according to an embodiment. The system 10 shown in Fig. 2 can be identical to the system 10 shown in Fig. 1.

For the sake of clarity, Fig. 2 shows the subgroups 12-1, 12-2, 12-3 of the antenna array side-by-side. The three subgroups 12-1, 12-2, 12-3 can be arranged concentrically around a common center point, as shown in Fig. 1, with subgroup 12-3 forming an inner ring, subgroup 12-2 forming a middle ring, and subgroup 12-1 forming an outer ring.

In particular, the weighting can result in each antenna element 14 in one subgroup 12-1, 12-2, 12-3 applying the same or a common phase and amplitude shift to a received respectively transmitted signal.

The weight generator 15 in Fig. 2 comprises means for digital weighting and means for analogue weighting. For example, the means for digital weighting comprise a digital baseband processors. Thereby, the weight generator 15 can comprise only one digital baseband processor for each subgroup 12-1, 12-2, 12-3.

The means for analog weighting can comprise a plurality of phase shifters and/or power amplifiers, e.g. one phase shifter and/or power amplifier for each antenna element 14 of each subgroup. The phase shifters and/or power amplifiers can be arranged in an RF chain between the means for digital beamforming and the antenna subgroups 12-1, 12-2, 12-3.

The system 10 can further comprise a plurality of connection lines of different lengths which are arranged to connect the weight generator with the antenna array subgroups 12-1, 12-2, 12-3. The lines can comprise cables, conductors and/or attenuators.

The transmitter and/or receiver device can be connected to the antenna array subgroups 12-1, 12-2, 12-3 via a connection device. For example, at least some components of the weight generator 15 and/or the lines connecting the weight generator 15 with the antenna array 12 can form part of the connection device.

Alternatively, the weight generator 15 itself can be a part of the antenna array 12 and/or the transmitting and/or receiving device 13.

The connection device can comprises at least one splitter and/or combiner unit. The at least one splitter and/or combiner unit can be connected to the plurality of antenna elements 14 of one of the subgroups 12-1, 12-2, 12-3 and can be configured to exchange signals between said antenna elements 14 and the transmitting and/or receiving device 13. E.g., input and/or output signals to/from the transmitter and/or receiver device can be transmitted in this way.

Thereby, the splitter unit can split an output signal from the transmitter and/or receiver device 13 into individual signal components which are forwarded to each antenna element 14 within the subgroup. The combiner unit can combine input signal components received at the individual antenna elements 14 of the subgroup, and forward the combined signal to the transmitter and/or receiver device 13.

In particular, the connection device can comprise separate devices for separate subgroups, e.g. a cable or a switch matrix. For example, all rings 12-1, 12-2, 12-3 can be connected to a vector network analyzer with switching for time division measurements. Alternatively, each subgroup can be connected to a port of a vector network analyzer (e.g., an 8-port vector network analyzer, VNA), wherein each port measures a particular ring. For a VNA with 8 ports, 8 scopes can be provided to the 8 individual rings of an antenna array.

The test system 10 shown in Figs. 1 and 2 can form a test setup for hybrid beamforming, in particular a hybrid plane wave converter (PWC).

For example, the system 10 allows switching between different sections of hybrid beamforming. Thereby, a subset can be be configure (analog PWC) or the location has to be clear (digital). The signal can be adjusted based on activated subset (digital).

## Claims

1. A test system (10) for testing a device-under-test, DUT (11), comprising:
a transmitting and/or receiving device (13); and
an antenna array (12) which is connected to the transmitting and/or receiving device (13);
wherein the antenna array (12) comprises a plurality of antenna elements (14) being grouped in at least two subgroups;
wherein the antenna elements (14) in at least one subgroup of the antenna array (12) are configured to apply an amplitude and/or phase shift to a signal which is transmitted to the DUT or received from the DUT;
**characterised in that** said amplitude and/or phase shift is provided by a weight generator (15) of the test system (10);
wherein the weight generator (15) is configured to provide the amplitude and/or phase shift to the antenna elements (14) of the at least one subgroup by means of an aggregated analog and digital weighting.

2. The test system (10) of claim 1,
wherein the weight generator (15) is configured to provide the same amplitude and/or phase shift to all antenna elements (14) in one subgroup of the antenna array (12).

3. The test system (10) of claim 1 or 2,
wherein the antenna elements (14) in each of the at least two subgroups form a respective ring around a central point of the antenna array (12).

4. The test system (10) of claim 3,
wherein the rings are arranged concentrically in a plane perpendicular to the DUT (11).

5. The test system (10) of any one of the preceding claims,
wherein the test system (10) comprises connection lines of different lengths which are arranged to connect the weight generator (15) with the at least two subgroups.

6. The test system (10) of any one of the preceding claims, further comprising:
a connection device which is arranged to connect the transmitter and/or receiver device (13) with the antenna elements (14) of the at least two subgroups,
wherein the connection device comprises at least one splitter and/or combiner unit.

7. The test system (10) of claim 6,
wherein at least one splitter and/or combiner unit of the connection device is connected to the plurality of antenna elements (14) in one of the subgroups, and is configured to exchange signals between said antenna elements (14) and the transmitting and/or receiving device (13).

8. The test system (10) of any one of the preceding claims,
wherein the weight generator (15) is configured to switch off at least one subgroup of the antenna array (12) based on the aggregated analog and digital weighting.

9. The test system (10) of any one of the preceding claims,
wherein each of the at least two subgroups of the antenna array (12) are operable in an activated and a deactivated operation mode.

10. The test system (10) of claim 9,
wherein the weight generator (15) is configured to activate and/or deactivate the respective subgroups based on a predefined activation sequence or based on feedback from the DUT (11).

11. The test system (10) of any one of the preceding claims,
wherein the weight generator (15) is configured to provide the amplitude and/or phase shift to the antenna elements of the respective subgroups based on a predefined weighting sequence or based on feedback from the DUT (11).

12. The test system (10) of claim 10 or 11,
wherein the weight generator (15) is configured to calculate the predefined activation sequence and/or the predefined weighting sequence based on a trainable algorithm, in particular a machine learning algorithm, which is trained by previously recorded data and/or signals.

13. The test system (10) of any one of the preceding claims,
wherein the weight generator (15) is configured to determine the amplitude and/or phase shift for the antenna elements of the at least one subgroup at least partially based on a distance between the DUT (11) and the antenna array (12).

## Patentansprüche

1. Testsystem (10) zum Testen einer zu testenden Vorrichtung, DUT (11), umfassend:
eine Sende- und/oder Empfangsvorrichtung (13); und
ein Antennenarray (12), das mit der Sende- und/oder Empfangsvorrichtung (13) verbunden ist;
wobei das Antennenarray (12) eine Vielzahl von Antennenelementen (14) umfasst, die in mindestens zwei Untergruppen gruppiert sind;
wobei die Antennenelemente (14) in mindestens einer Untergruppe des Antennenarrays (12) konfiguriert sind, um eine Amplitude und/oder Phasenverschiebung auf ein Signal anzuwenden, das an die DUT gesendet oder von der DUT empfangen wird;
**dadurch gekennzeichnet, dass** die Amplitude und/oder Phasenverschiebung durch einen Gewichtungsgenerator (15) des Testsystems (10) bereitgestellt wird;
wobei der Gewichtungsgenerator (15) konfiguriert ist, um die Amplitude und/oder Phasenverschiebung zu den Antennenelementen (14) der mindestens einen Untergruppe mittels einer aggregierten analogen und digitalen Gewichtung bereitzustellen.

2. Testsystem (10) nach Anspruch 1,
wobei der Gewichtungsgenerator (15) konfiguriert ist, um die gleiche Amplitude und/oder Phasenverschiebung zu allen Antennenelementen (14) in einer Untergruppe des Antennenarrays (12) bereitzustellen.

3. Testsystem (10) nach Anspruch 1 oder 2,
wobei die Antennenelemente (14) in jeder der mindestens zwei Untergruppen einen jeweiligen Ring um einen Mittelpunkt des Antennenarrays (12) bilden.

4. Testsystem (10) nach Anspruch 3,
wobei die Ringe in einer Ebene senkrecht zu der DUT (11) konzentrisch angeordnet sind.

5. Testsystem (10) nach einem der vorstehenden Ansprüche,
wobei das Testsystem (10) Verbindungsleitungen unterschiedlicher Längen umfasst, die angeordnet sind, um den Gewichtungsgenerator (15) mit den mindestens zwei Untergruppen zu verbinden.

6. Testsystem (10) nach einem der vorstehenden Ansprüche, ferner umfassend:
eine Verbindungsvorrichtung, die angeordnet ist, um die Sender- und/oder Empfängervorrichtung (13) mit den Antennenelementen (14) der mindestens zwei Untergruppen zu verbinden,
wobei die Verbindungsvorrichtung mindestens eine Splitter- und/oder Kombinierungseinheit umfasst.

7. Testsystem (10) nach Anspruch 6,
wobei mindestens eine Splitter- und/oder Kombinierungseinheit der Verbindungsvorrichtung mit der Vielzahl von Antennenelementen (14) in einer der Untergruppen verbunden ist, und konfiguriert ist, um Signale zwischen den Antennenelementen (14) und der Sende- und/oder Empfangsvorrichtung (13) auszutauschen.

8. Testsystem (10) nach einem der vorstehenden Ansprüche,
wobei der Gewichtungsgenerator (15) konfiguriert ist, um mindestens eine Untergruppe des Antennenarrays (12) basierend auf der aggregierten analogen und digitalen Gewichtung auszuschalten.

9. Testsystem (10) nach einem der vorstehenden Ansprüche,
wobei jede der mindestens zwei Untergruppen des Antennenarrays (12) in einem aktivierten und einem deaktivierten Betriebsmodus betreibbar ist.

10. Testsystem (10) nach Anspruch 9,
wobei der Gewichtungsgenerator (15) konfiguriert ist, um die jeweiligen Untergruppen basierend auf einer vordefinierten Aktivierungssequenz oder basierend auf einer Rückmeldung von der DUT (11) zu aktivieren und/oder zu deaktivieren.

11. Testsystem (10) nach einem der vorstehenden Ansprüche,
wobei der Gewichtungsgenerator (15) konfiguriert ist, um die Amplitude und/oder Phasenverschiebung zu den Antennenelementen der jeweiligen Untergruppen basierend auf einer vordefinierten Gewichtungssequenz oder basierend auf einer Rückmeldung von der DUT (11) bereitzustellen.

12. Testsystem (10) nach Anspruch 10 oder 11,
wobei der Gewichtungsgenerator (15) konfiguriert ist, um die vordefinierte Aktivierungssequenz und/oder die vordefinierte Gewichtungssequenz basierend auf einem trainierbaren Algorithmus, insbesondere einem Maschinenlernalgorithmus, zu berechnen, der durch zuvor aufgezeichnete Daten und/oder Signale trainiert wird.

13. Testsystem (10) nach einem der vorstehenden Ansprüche,
wobei der Gewichtungsgenerator (15) konfiguriert ist, um die Amplitude und/oder Phasenverschiebung für die Antennenelemente der mindestens einen Untergruppe mindestens teilweise basierend auf einem Abstand zwischen der DUT (11) und dem Antennenarray (12) zu bestimmen.

## Revendications

1. Système d'essai (10) permettant de soumettre à un essai un dispositif soumis à l'essai, DSE (11), comprenant :
un dispositif d'émission et/ou de réception (13) ; et
un réseau d'antennes (12) qui est connecté au dispositif d'émission et/ou de réception (13) ;
dans lequel le réseau d'antennes (12) comprend une pluralité d'éléments d'antenne (14) étant groupés dans au moins deux sous-groupes ;
dans lequel les éléments d'antenne (14) dans au moins un sous-groupe du réseau d'antennes (12) sont configurés pour appliquer un déplacement d'amplitude et/ou de phase à un signal qui est émis vers le DES ou reçu à partir du DSE ;
**caractérisé en ce que** ledit déplacement d'amplitude et/ou de phase est fourni par un générateur de poids (15) du système d'essai (10) ;
dans lequel le générateur de poids (15) est configuré pour fournir le déplacement d'amplitude et/ou de phase aux éléments d'antenne (14) de l'au moins un sous-groupe au moyen d'une pondération analogique et numérique agrégée.

2. Système d'essai (10) selon la revendication 1,
dans lequel le générateur de poids (15) est configuré pour fournir le même déplacement d'amplitude et/ou de phase à tous les éléments d'antenne (14) dans un sous-groupe du réseau d'antennes (12).

3. Système d'essai (10) selon la revendication 1 ou 2,
dans lequel les éléments d'antenne (14) dans chacun des au moins deux sous-groupes forment un anneau respectif autour d'un point central du réseau d'antennes (12).

4. Système d'essai (10) selon la revendication 3,
dans lequel les anneaux sont agencés de manière concentrique dans un plan perpendiculaire au DSE (11).

5. Système d'essai (10) selon l'une quelconque des revendications précédentes,
dans lequel le système d'essai (10) comprend des lignes de connexion de longueurs différentes qui sont agencées pour connecter le générateur de poids (15) aux au moins deux sous-groupes.

6. Système d'essai (10) selon l'une quelconque des revendications précédentes, comprenant en outre :
un dispositif de connexion qui est agencé pour connecter le dispositif émetteur et/ou récepteur (13) aux éléments d'antenne (14) des au moins deux sous-groupes,
dans lequel le dispositif de connexion comprend au moins un diviseur et/ou combineur.

7. Système d'essai (10) selon la revendication 6,
dans lequel au moins un diviseur et/ou combineur du dispositif de connexion est connecté à la pluralité d'éléments d'antenne (14) dans l'un des sous-groupes, et est configuré pour échanger des signaux entre lesdits éléments d'antenne (14) et le dispositif d'émission et/ou de réception (13).

8. Système d'essai (10) selon l'une quelconque des revendications précédentes,
dans lequel le générateur de poids (15) est configuré pour éteindre au moins un sous-groupe du réseau d'antennes (12) sur la base de la pondération analogique et numérique agrégée.

9. Système d'essai (10) selon l'une quelconque des revendications précédentes,
dans lequel chacun des au moins deux sous-groupes du réseau d'antennes (12) sont exploitables dans un mode de fonctionnement activé et désactivé.

10. Système d'essai (10) selon la revendication 9,
dans lequel le générateur de poids (15) est configuré pour activer et/ou désactiver les sous-groupes respectifs sur la base d'une séquence d'activation prédéfinie ou sur la base d'un retour provenant du DSE (11).

11. Système d'essai (10) selon l'une quelconque des revendications précédentes,
dans lequel le générateur de poids (15) est configuré pour fournir le déplacement d'amplitude et/ou de phase aux éléments d'antenne des sous-groupes respectifs sur la base d'une séquence de pondération prédéfinie ou sur la base d'un retour provenant du DSE (11).

12. Système d'essai (10) selon la revendication 10 ou 11,
dans lequel le générateur de poids (15) est configuré pour calculer la séquence d'activation prédéfinie et/ou la séquence de pondération prédéfinie sur la base d'un algorithme susceptible d'être formé, en particulier un algorithme d'apprentissage automatique, qui est formé par des données et/ou signaux précédemment enregistrés.

13. Système d'essai (10) selon l'une quelconque des revendications précédentes,
dans lequel le générateur de poids (15) est configuré pour déterminer le déplacement d'amplitude et/ou de phase pour les éléments d'antenne de l'au moins un sous-groupe sur la base au moins partiellement d'une distance entre le DSE (11) et le réseau d'antennes (12).
